# EUROPÄISCHE PATENTSCHRIFT

(11) **EP 0 558 793 B1**
(45) Veröffentlichungstag und Bekanntmachung des Hinweises auf die Patenterteilung: **01.03.2000**
(21) Anmeldenummer: 92111342.9
(22) Anmeldetag: 03.07.1992
(51) Int. Cl.: H03F 1/32, H03F 1/02

(54) **Verfahren zum linearen Verstärken eines Nutzsignals und Verstärker zum Durchführen des Verfahrens**
Method for linear amplification of a useful signal and amplifier for the realisation of this method
Procédé pour l'amplification linéaire d'un signal utile et amplificateur pour réaliser ce procédé

(30) Priorität: 29.02.1992 DE 4206352
(43) Veröffentlichungstag der Anmeldung: 08.09.1993
(73) Patentinhaber: DaimlerChrysler Aerospace Aktiengesellschaft, 89077 Ulm (DE)
(72) Erfinder: Boschka, Wilfried, W-7900 Ulm 7 (DE); Esprester, Ralf, Dr., W-7909 Dornstadt (DE); Kombrink, Friedemann, W-7907 Langenau-Hörvelsingen (DE)
(74) Vertreter: Straub, Bernd

(56) Entgegenhaltungen:
- EP-A- 0 171 843
- EP-A- 0 431 201
- FR-A- 2 532 491
- US-A- 3 720 880

## Beschreibung

Die Erfindung bezieht sich auf ein Verfahren zum linearen Verstärken eines Nutzsignals gemäß Oberbegriff des Patentanspruchs 1 sowie auf einen Verstärker zum Durchführen dieses Verfahrens gemäß Oberbegriff des Patentanspruchs 8. Ein solches Verfahren bzw. ein solcher Verstärker sind bereits aus der US-A-3,720,880 bekannt. Zwar werden, wenn es darum geht, einen möglichst hohen Verstärkungswirkungsgrad zu erzielen, wegen ihres prinzipiell hohen Wirkungsgrades mit Werten von typisch 70 % und mehr insbesondere im Hochleistungsbereich in zunehmendem Maße Schaltverstärker eingesetzt. Diesen Verstärkern müssen jedoch, wenn es um eine möglichst lineare Verstärkung (d.h. um eine möglichst gute Unterdrückung von unerwünschten Oberwellen usw.) geht, aufwendige Filterstrukturen nachgeschaltet werden, die in der Praxis häufig jedoch nicht ausreichen, um die durch den Schaltprozeß hervorgerufenen (unerwünschten) Spektralanteile im Ausgangssignal des Verstärkers in genügendem Maße herauszufiltern. Deshalb werden in vielen Anwendungen auch heute noch - trotz ihres relativ niedrigen Wirkungsgrades von typisch 30 bis 40 % - herkömmliche Linearverstärker eingesetzt, weil sie, sofern sie im linearen Bereich der Verstärkerkennlinie arbeiten, per se das zu verstärkende Nutzsignal nahezu unverzerrt (d.h. mit wenig störenden Oberwellenanteilen) verstärken.

Besonders hohe Anforderungen an die spektrale Reinheit der verstärkten Nutzsignale bestehen bei Einseitenbandsendern, insbesondere bei solchen Sendern des LW-, MW- und KW-Bereichs (LW=Langwelle, MW=Mittelwelle, KW=Kurzwelle) infolge der dichten Belegung der Frequenzbänder in diesen Bereichen. Deshalb werden in den Hochfrequenz(HF)-Endstufen solcher Sender auch heute noch überwiegend lineare HF-Verstärker eingesetzt.

Mit bisher realisierten linearen Transistor-Leistungsverstärkern konnten - wegen den strengen Linearitätsforderungen (u.a.: IM3 ≥ 36dB PEP mit IM3 = Intermodulationsprodukte 3.Ordnung und PEP = Peak-Envelope-Power (Nennleistung)) - bislang auch nur Wirkungsgrade von 30 bis 40 % erreicht werden.

Die Verlustleistung ist durch die hohe Versorgungsspannungsreserve bedingt, die zur Erreichung der geforderten Linearitätadaten von beispielsweise IM3 ≥ 36 dB PEP und zur gleichzeitigen Erfüllung des Stehwellenverhältnisses von 2:1 bei Nennleistungsbedingungen notwendig ist.

In der US-A- 3,720,880 wird ein solcher Linearverstärker beschrieben, der zur Steigerung des Wirkungsgrads und zur Linearisierung mit einer gesteuerten Versorgungsspannung betrieben wird. Bei dieser Lösung ist der Eingang des Verstärkers zusätzlich über einen Hüllkurvendetektor mit einem variablen Verstärker verbunden, dessen Ausgang die Versorgungsspannung des Verstärkers steuert. Der variable Verstärker hat dabei die Aufgabe, eine Mindest-Versorgungsspannung (d.h. eine Offset-Spannung) einzustellen sowie diese Offset-Spannung zu einer Spannung hinzuzuaddieren, die in etwa proportional zur Hüllkurve des Eingangssignals ist.

Ein ähnlich wirkender Linearverstärker ist aus der EP 0 171 843 A2 bekannt. Bei dieser Lösung wird ein Hüllkurven-Regelsignal verwendet, um die Kollektor-Versorgungsspannung eines bipoloaren Hochfrequenz-Leistungstransistors einzustellen. Das Hüllkurven-Regelsignal wird aus dem Eingangs- und Ausgangssignal des Leistungstransistors abgeleitet, in dem das Eingangssignal und das Ausgangssignal über gegensätzlich polarisierte Diodendetektoren einem weiteren Verstärker zugleitet und dort addiert werden. Dabei ist dem Diodendetektor im Abzweig für das Verstärkerausgangssignal ein Dämpfungsglied vorgeschaltet. Das Ausgangssignal des weiteren Verstärkers dient als Steuersignal für eine variable Versorgungsspannungseinheit, mit der die Kollektorspannung des Leistungstransistors eingestellt wird. Die Versorgungsspannung wird dabei so gewählt, daß die Linearität für Amplitude und Phase für alle vorkommenden Signalleistungspegel möglichst optimal ist und der Wirkungsgrad des Linearverstärkers möglichst hoch ist.

Ferner ist aus der FR-A-2 532 491 ein Linearverstärker bekannt, bei dem die Linearisierung der Verstärkung durch ein regelbares Dämpfungsglied erreicht wird.

Schließlich ist aus der EP 0 431 201 B1 ein Linearverstärker bekannt, bei dem ebenfalls die Betriebsspannung in Abhängigkeit der Einhüllenden des Nutzsignals eingestellt wird.

Bei all den geschilderten Verstärkern handelt es sich um reine Linearverstärker, die nicht in die Kompression gefahren werden und die auch kein Oberwellenfilter enthalten.

Es wurde allerdings auch ein auf Kahn zurückgehendes Verstärkungsverfahren für Sender vorgeschlagen, das einen höheren Wirkungsgrad ermöglicht. Bei diesen Verfahren wird das mit dem Modulationssignal modulierte HF-Steuersignal für die HF-Endstufe des Senders in zwei Signalanteile aufgespalten: in einen ersten Anteil, der nur noch die Phaseninformation enthält (also konstante Amplitude aufweist) und der dem Steuereingang des HF-Endstufenverstärkers zugeführt wird, und einen zweiten Anteil, der nur noch die Amplitudeninformation enthält (die dem Modulationssignal entsprechende "Einhüllende" des HF-Signals) und der dazu benutzt wird, einen pulsdauermodulierten(PDM) Leistungssteller anzusteuern, der die Versorgungsspannung U_{B} des HF-Endstufenverstärkers proportional zur momentanen Amplitude der Einhüllenden "pulsdauermoduliert", d.h. zerhackt.

In einer nachgeschalteten Filtereinheit werden aus diesen, in ihrer Breite pulsdauermodulierten Spannungsimpulsen konstanter Amplitude die Oberwellen wieder herausgefiltert, so daß der Verlauf der "geglätteten" Versorgungsspannung im Idealfall direkt proportional ist zum Verlauf der Einhüllenden. Dieses im Hinblick auf den Verstärkerwirkungsgrad an sich vorteilhafte Verfahren weist jedoch insbesondere bei Einseitenbandsendern in der Praxis erhebliche Nachteile auf.

So muß der PDM-Leistungssteller wegen der Spitzen beim Nulldurchgang der Einhüllenden bei einer 2-Ton-Aussteuerung gleicher Amplitude im Prinzip eine "unendliche", d.h. in der Praxis eine sehr große Bandbreite haben.

Ferner lassen sich kleine Amplituden am HF-Endstufenverstärkerausgang wegen der nicht genügenden Entkopplung zwischen den Ein- und Ausgängen der elektronischen Verstärker-Bauelemente und damit des Verstärkers nur sehr schwer realisieren.

Außerdem können herkömmliche Steuersignalgeneratoren für die HF-Endstufe bei dem Verstärkungsverfahren nach Kahn i.a. nicht verwendet werden, da mit diesen Generatoren ein nach Phase und Amplitude getrennt aufbereitetes Steuersignal nicht ohne weiteres erzeugt werden kann.

Schließlich ergeben sich große Probleme bei der Erfüllung der Anforderungen nach spektraler Reinheit des Ausgangssignals des HF-Endstufenverstärkers; dies ist vor allem darin begründet, daß beim Nulldurchgang des modulierten HF-Signals ein Phasen-Sprung stattfindet.

Die Aufgabe der Erfindung besteht darin, zum einen ein Verfahren zum linearen Verstärken eines Nutzsignals anzugeben, mit dem ein möglichst hoher Verstärkerwirkungsgrad erzielt werden kann und gleichzeitig das zu verstärkende Signal möglichst unverzerrt verstärkt werden kann, bzw. zum anderen einen Verstärker zum Durchführen des Verfahrens zu schaffen, der möglichst einfach im Aufbau ist.

Die erfindungsgemäße Lösung ist in bezug auf das zu schaffende Verfahren durch die kennzeichnenden Merkmale des Patentanspruchs 1 und in bezug auf den zu schaffenden Verstärker durch die kennzeichnenden Merkmale des Patentanspruchs 8 wiedergegeben. Die übrigen Ansprüche enthalten vorteilhafte Aus- und Weiterbildungen des erfindungsgemäßen Verfahrens (Ansprüche 2 bis 7) bzw. des erfindungsgemäßen Verstärkers (Ansprüche 9 bis 19) sowie bevorzugte Anwendungsgebiete des erfindungsgemäßen Verfahrens bzw. Verstärkers (Anspruch 20).

Das erfindungsgemäße Verfahren ist dadurch gekennzeichnet, daß die Versorgungsspannung, ausgehend von einem vorgegebenen Mindestwert, der nicht unterschritten wird, in ihrem zeitlichen Verlauf in Abhängigkeit von der Einhüllenden des Nutzsignals nachgeführt wird, dergestalt, daß der Verstärker bei kleineren Signalamplitudenwerten der Einhüllenden des Nutzsignals im linearen Arbeitsbereich betrieben wird und bei größeren Signalamplitudenwerten in die Kompression gesteuert wird.

In einer ersten bevorzugten Ausführungsform des erfindungsgemäßen Verfahrens ist vorgesehen, daß der Mindestwert der Versorgungsspannung so ausgewählt wird, daß die Versorgungsspannung, von diesem Mindestwert ausgehend, mit größer werdender Signalamplitude der Einhüllenden des Nutzsignals ansteigt, dergestalt, daß der Verstärker, ausgehend von der Signalamplitude Null, mit größer werdender Signalamplitude zunächst im linearen Arbeitsbereich betrieben wird und dann allmählich in die Kompression gesteuert wird.

Bei dieser Ausführungsform des erfindungsgemäßen Verfahrens folgt die Versorgungsspannung, ausgehend von dem Mindestwert, in ihrem zeitlichen Verlauf dem zeitlichen Verlauf der Einhüllenden des Nutzsignals (ohne daß dabei der Mindestwert unterschritten wird), sobald das Modulationssignal bzw. die Einhüllende einen Amplitudenwert verschieden von Null aufweist.

In einer zweiten bevorzugten Ausführungsform des erfindungsgemäßen Verfahrens ist vorgesehen, daß innerhalb des zulässigen Signalamplitudenbereichs der Einhüllenden des Nutzsignals ein bestimmter Signalamplitudenwert als Schwellenwert ausgewählt wird, daß für die zulässigen Signalamplituden der Einhüllenden des Nutzsignals, die kleiner oder gleich diesem Schwellenwert sind, die Versorgungsspannung auf einem Mindestwert konstant oder zumindest annähernd konstant gehalten wird und der Verstärker in linearen Arbeitsbereich betrieben wird und für die übrigen zulässigen Signalamplituden, die größer als dieser Schwellenwert sind, die Versorgungsspannung, von diesen Mindestwert ausgehend, proportional oder zumindest annähernd proportional zur momentanen Signalamplitude der Einhüllenden des Nutzsignals verändert wird und der Verstärker durch das Nutzsignal in die Kompression gesteuert wird.

Bei dieser Ausführungsform des erfindungsgemäßen Verfahrens folgt die Versorgungsspannung, ausgehend von dem vorgegebenen Mindestwert, in ihren zeitlichen Verlauf dem zeitlichen Verlauf der Einhüllenden des Nutzsignals erst dann , wenn die momentane Signalamplitude der Einhüllenden des Nutzsignals den vorgegebenen Schwellenwert überschritten hat. Aber auch bei dieser Ausführungsform wird der Mindestwert der Versorgungsspannung nicht unterschritten.

Ein wesentlicher Vorteil des erfindungsgemäßen Verfahrens bzw. des erfindungsgemäßen Verstärkers besteht darin, daß ein im Vergleich zu herkömmlichen Linearverstärkern hoher Wirkungsgrad erzielt wird, der durchaus in die Nähe des Wirkungsgrades von echten Schaltverstärkern kommt, und daß gleichzeitig eine hohe Linearität (geringer Verzerrungsgrad bzw. Klirrfaktor) bei der Verstärkung erreicht wird, die sich durchaus mit der Linearität von herkömmlichen linearen Verstärkern messen kann.

Ein weiterer Vorteil der Erfindung besteht darin, daß im Vergleich zu herkömmlichen Linearverstärkern eine neue Generation von Verstärkern, insbesonder von Senderverstärkern mit erheblich günstigerem Gesamtwirkungsgrad und mindestens gleichwertigen elektrischen Daten zu erheblich reduzierten Herstellkosten realisiert werden kann, die sich vor allem für den Einsatz in Sendern, insbesondere Einseitenbandsendern eignen.

Außerdem können zur Ansteuerung des erfindungsgemäßen Verstärkers ohne weiteres herkömmliche Steuersignalgeneratoren , die das Nutzsignal aufbereiten, bzw. lineare Vorverstärker, die dem jeweiligen Steuergenerator nachgeschaltet sind, verwendet werden. Als besonders vorteilhaft hat es sich im Hinblick auf den erreichbaren Wirkungsgrad bzw. die erreichbare Linearität erwiesen, wenn der beim erfindungsgemäßen Verfahren vorgesehene Mindestwert der Versorgungsspannung kleiner als die maximal mögliche Versorgungsspannung bzw. der bestimmte Signalamplitudenwert (Schwellenwert) kleiner als der maximal zulässige Signalamplitudenwert der Einhüllenden des Nutzsignals ist und dabei vorzugsweise kleiner als das 0,5-fache dieses (jeweiligen) Maximalwertes, vorzugsweise kleiner als das 0,4-fache dieses (jeweiligen) Maximalwertes ist und insbesondere im Bereich des 0,03- bis 0,3-fachen dieses (jeweiligen) Maximalwertes, vorzugsweise bei etwa dem 0,1-fachen oder bei etwa dem 0,2-fachen dieses (jeweiligen) Maximalwertes liegt.

Weiterhin hat sich als besonders vorteilhaft erwiesen, wenn der Mindestwert der Versorgungsspannung bzw. der bestimmte Signalamplitudenwert (Schwellenwert) in Abhängigkeit weiterer Betriebsparameter festgelegt und/oder während des Betriebes des Verstärkers verändert wird, insbesondere in Abhängigkeit vom gemessenen mittleren Verstärkerwirkungsgrad und/oder von dem ermittelten mittleren Modulationsgrad und/oder von dem ermittelten mittleren Klirrfaktor des Verstärkerausgangssignals und/oder von der ermittelten momentanen Betriebstemperatur des Verstärkers.

In einer bevorzugten Ausführungsform des erfindungsgemäßen Verstärkers zum Durchführen des erfindungsgemäßen Verfahrens ist ein Oberwellenfilter vorgesehen, das den Verstärker besonders befähigt, für kleine Signalpegel im linearen Arbeitsbereich zu arbeiten und für große Signalpegel in die Kompression gesteuert zu werden.

Im folgenden wird die Erfindung anhand der Figuren näher erläutert. Es zeigen:
- FIG. 1: Typische Spannungs-Zeitverläufe der Versorgungsspannung, der Einhüllenden eines amplitudengleichen 2-Ton- modulierten HF-Nutzsignals einer bevorzugten Ausführungsform des erfindungsgemäßen Verstärkers;
- FIG. 2: Das Frequenzspektrum eines nach einer bevorzugten Ausführungsform des erfindungsgemäßen Verfahrens verstärkten Nutzsignals für den Fall einer Intermodulation zweier Töne der Frequenz f₁ und f₂ im Vergleich zu dem entsprechenden Frequenzspektrum des Ausgangssignals eines in die Kompression gesteuerten, aber nicht "linearisierten" Quasi-Schaltverstärkers;
- FIG. 3: das Blockschaltbild eines Verstärkers zum Durchführen des erfindungsgemäßen Verfahrens;
- FIG. 4-10: Blockschaltbilder bevorzugter Ausführungsbeispiele des erfindungsgemäßen Verstärkers zum Durchführen des erfindungsgemäßen Verfahrens.

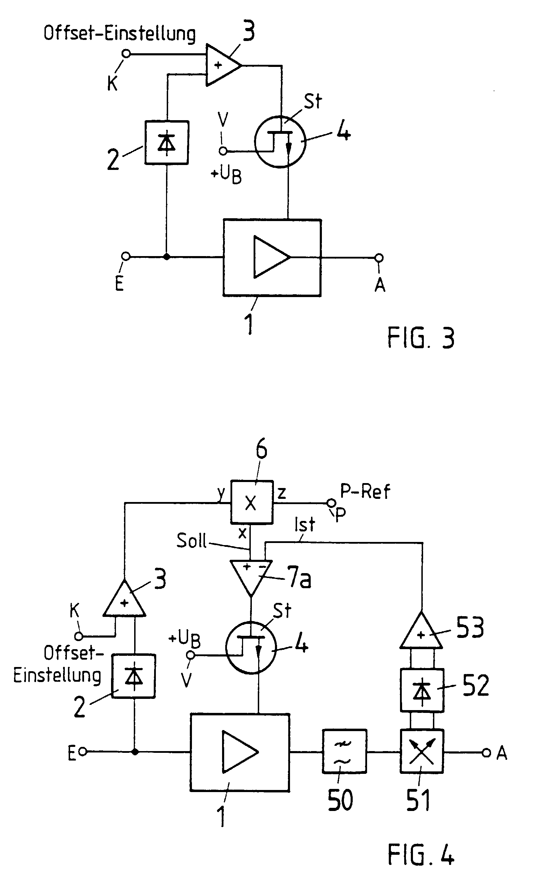

In all diesen Verstärkern der Figuren 3 bis 10 wird Gebrauch gemacht von sogenannten "linearisierten" Quasi-Schaltverstärkern. Quasi-Schaltverstärker sind Linearverstärker, die in den Kompressionsbereich gesteuert werden (beispielsweise bis zum 3dB- oder 5dB-Kompressionspunkt) und damit fast wie ein Schaltverstärker arbeiten.

Solcherart betriebene Verstärker erreichen einen wesentlich höheren Wirkungsgrad als herkömmlich betriebene Linearverstärker (70 bis 80 % gegenüber 30 bis 40 %).

Soweit in die Kompression gefahrene Verstärker zeigen jedoch wesentlich ungünstigere Linearitätswerte; so liegt z.B. der Intermodulationsabstand eines solchen Verstärkers bei 2 Ton-Intermodulation typisch bei nur 20dB, bei herkömmlicher Betriebsweise (Einzelfrequenzsignal) etwa bei Werten > 30dB.

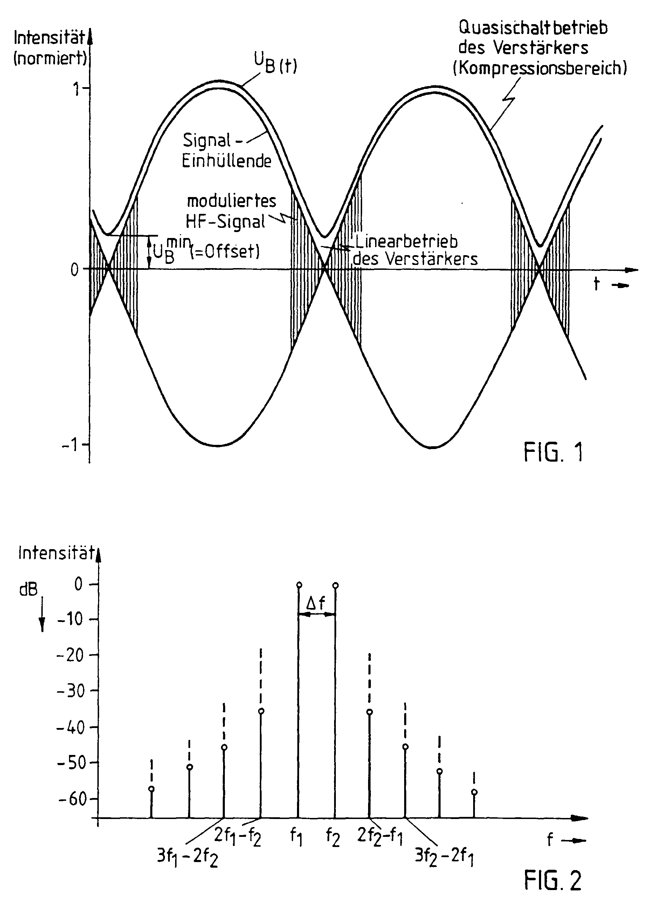

Diese durch die Kompression verursachte Nichtlinearität wird beim erfindungsgemäßen Verstärker gar nicht erst wirksam, da dessen zugeführte Versorgungsspannung U_{B} der Einhüllenden des Nutzsignals nachgefahren wird. Dies verdeutlicht zum einen FIG. 1, in der typische (auf 1 normierte) Spannungs-Zeitverläufe der Versorgungsspannung U_{B}(t) und der Einhüllenden eines 2-Ton-modulierten HF-Nutzsignals eines nach dem erfindungsgemäßen Verfahren arbeitenden "linearisierten" Quasi-Schaltverstärkers gezeigt werden, und zum anderen FIG. 2, in der das Frequenzspektrum eines nach einem bevorzugten Ausführungsbeispiels des erfindungsgemäßen Verfahrens verstärkten Nutzsignals für den Fall einer Intermodulation zweier Töne der Frequenzen f₁ und f₂ (durchgezogene Linien in FIG. 2) im Vergleich zum Frequenzspektrum eines nicht "linearisierten" Quasi-Schaltverstärkers, d.h. eines in die Kompression gefahrenen herkömmlichen Linearverstärkers (gestrichelte Linien in FIG. 2) gezeigt wird. Der Vergleich ergibt, daß die (unerwünschten) Intermodulationsprodukte (2f₁-f₂, 2f₂-f₁, 3f₂-2f₁, 3f₁-2f₂ usw.) des herkömmlichen Quasi-Schaltverstärkers eine um bis zu ca. 15dB höhere Intensität aufweisen als die entsprechenden Intermodulationsprodukte des "linearisierten" Quasi-Schaltverstärkers.

Die Referenz für die in FIG. 1 dargestellte Einhüllende des HF-Nutzsignals erhält man z.B. durch Gleichrichten der Amplitude des Eingangssignals des Verstärkers bzw. des Ausgangssignals eines gegebenenfalls vorgeschalteten linearen Vorstufen-Verstärkers. Dies kann z.B. das bereits verstärkte Signal eines herkömmlichen Steuersignalgenerators sein. Zur Erzeugung der der Einhüllenden "nachfahrenden" Versorgungsspannung U_{B} für den auf diese Weise linearisierten Quasi-Schaltverstärker kann beispielsweise ein einfacher Gleichspannungsverstärker vorgesehen werden, bestehend aus einem Operationeverstärker und einem von diesem Operationsverstärker angesteuerten linearen Leistungsstellglied (z.B. in Form eines als Emitterfolger geschalteten Leistungstransistors oder eines PDM-Stellers).

Wie aus FIG. 1 hervorgeht, steht ein weiteres Merkmal der Erfindung im Zusammenhang mit dem Kleinsignalverhalten. Die gemäß der Einhüllenden des Nutzsignals variierende Versorgungsspannung U_{B} erhält einen Offset, der eine Mindestversorgungsspannung U_{B}^{min} darstellt, welche nicht unterschritten wird. Auf diese Weise ist gewährleistet, daß Signale kleiner Amplitude nicht in die Kompression gefahren werden, d.h. linear verstärkt werden. Dies ist deshalb wichtig, weil es sich gezeigt hat, daß gerade hier der wunde Punkt der echten Schaltverstärker-Endstufen liegt. Diese erzeugen aus dem Signal kleiner Amplitude mit an sich brauchbarem Signalspektrum ein unbrauchbares breitbandiges Störsignal, welches vom Gesichtspunkt der erforderlichen spektralen Reinheit i.a. untauglich ist.

In den folgenden Figuren 3 bis 10 sind bevorzugte Ausführungsbeispiele des erfindungsgemäßen Verstärkers (FIG. 4 bis 10) sowie ein weiterer Verstärker (FIG. 3) zum Durchführen des erfindungsgemäßen Verfahrens gezeigt. Dabei sind in allen Figuren konsistent gleiche Baugruppen immer mit den gleichen Bezugszeichen versehen. Dementsprechend wurde die Beschreibung der Figuren dahingehend zusammengefaßt, daß die in mehreren Figuren vorkommenden Schaltungsteile nur einmal, nämlich bei ihrer erstmaligen Erwähnung in der Beschreibung einer der Figuren, näher erläutert werden und im folgenden auf diese Beschreibungen jeweils Bezug genommen wird mit der Folge, daß bei der Beschreibung der einzelnen Figuren jeweils nur die Unterschiede zu bereits beschriebenen Figuren herausgestellt und näher diskutiert werden.

In FIG. 3 ist ein Verstärker zum Durchführen des erfindungsgemäßen Verfahrens gezeigt.

Der Verstärker 1 weist einen Eingang E und einen Ausgang A auf. Der Eingang E, an den das aufbereitete modulierte Nutzsignal anliegt, ist zusätzlich über ein Hüllkurvendetektor 2 und einen Operationsverstärker 3 mit dem Steuereingang St eines linearen Stellglieds 4 verbunden. Die Klemme V für die Versorgungsspannung U_{B} ist über das Stellglied 4 mit dem Verstärker 1 verbunden. Dem Operationsverstärker 3 ist über die Klemme K zusätzlich eine Vergleichsspannung zugeführt zur Einstellung des Mindestwertes, d.h. des Offsets (U_{B}^{min}) der Versorgungsspannung U_{B} des Verstärkers 1.

Die Höhe des Offsets (U_{B}^{min} in FIG. 1) der Versorgungsspannung U_{B} ist so gewählt, daß die Versorgungsspannung U_{B}(t), von diesem Offset-Wert ausgehend, mit größer werdender Signalamplitude der Einhüllenden des an Eingang E des Verstärkers 1 anliegenden Nutzsignals ansteigt, und zwar dergestalt, daß der Verstärker 1, ausgehend von der Signalamplitude Null der Einhüllenden des Nutzsignals, mit größer werdender Signalamplitude zunächst im linearen Arbeitsbereich betrieben wird und dann allmählich in die Kompression gesteuert wird.

Erreicht wird dies, indem der Hüllkurvendetektor aus dem am Eingang E des Verstärkers 1 anliegenden modulierten Nutzsignal die (dem niederfrequenteren) Modulationssignal entsprechende "Einhüllende" des Nutzsignals erzeugt, die im als Addierer bzw. Summierverstärker wirkenden Operationsverstärker 3 mit der von außen vorgegebenen Vergleichsspannung ("Offset-Einstellung") addiert wird. Dieses "Addierer"-Ausgangssignal dient als Steuersignal für das lineare Stellglied 4 (in der FIG. 3 beispielhaft ein Leistungs-MOS-Feldeffekttransistor) mit der unmittelbaren Folge, daß auch die am Ausgang vom Stellglied 4 entstehende Versorgungsspannung U_{B}(t) des Verstärkers 1 durch das Stellglied 4 in ihrem Wert proportional zum Momentanwert dieses "Addierer"-Ausgangssignal verändert wird, so daß sich im Endeffekt die in FIG. 1 dargestellten prinzipiellen Spannungs-Zeitverläufe der Betriebsspannung U_{B}(t) und der Einhüllenden des modulierten Nutzsignals ergeben. Dabei ist zu beachten, daß die in einem ersten theoretischen Ansatz bei U_{B}^{min} (Offset) an sich spitz zusammenlaufenden Kurventeile von U_{B}(t) in Wirklichkeit natürlich in Form eines "gerundeten" Kurvenverlaufs ineinander übergehen, oder mit anderen Worten, daß die Steigung von U_{B}(t) in der näheren Umgebung von U_{B}^{min} und bei U_{B}^{min} selbst stetig ist.

In FIG. 4 ist ein erstes Ausführungsbeispiel des erfindungsgemäßen Verstärkers gezeigt. Es unterscheidet sich von dem in FIG. 3 gezeigten Verstärker dadurch, daß zusätzlich ein Leistungsregelkreis (Komponenten 51, 52, 53) vorgesehen ist, der die Ausgangsleistung am Ausgang A des Verstärkers 1 nach einem vorgegebenen Sollwert P-Ref regelt. Mit 51 ist dabei ein Richtkoppler bezeichnet, welcher das vor- und rücklaufende Nutzsignal am Ausgang A des Verstärkers 1 mißt, mit 52 ein Hüllkurvendetektor, der die Einhüllende dieser beiden Signale bildet, welche in einem Summierverstärker 53 addiert und verstärkt werden. Ferner wird in diesem Ausführungsbeispiel jeder Augenblickswert der Hüllkurve am Eingang E und am Ausgang A des Verstärkers in einem Operationsverstärker 7a verglichen und Abweichungen über das Stellglied 4 korrigiert; diese Maßnahme dient zur Verbesserung der Linearität des Ausgangssignals am Ausgang A des Verstärkers. Ein Multiplizierer 6 liefert dabei das der Soll-Sende-Leistung P-Ref entsprechende Einhüllendensignal aus der Einhüllenden des gepegelten Eingangssignals am Eingang E des Verstärkers 1. Der Multiplizierer 6 kann z.B. in Form eines regelbaren NF-Verstärkers ausgebildet sein. In einem dem Verstärker 1 nachgeschalteten Tiefpaßfilter 50 wird ferner das Ausgangssignal des Verstärkers 1 weitgehend von den (unerwünschten) Oberwellen befreit ("Oberwellenfilter").

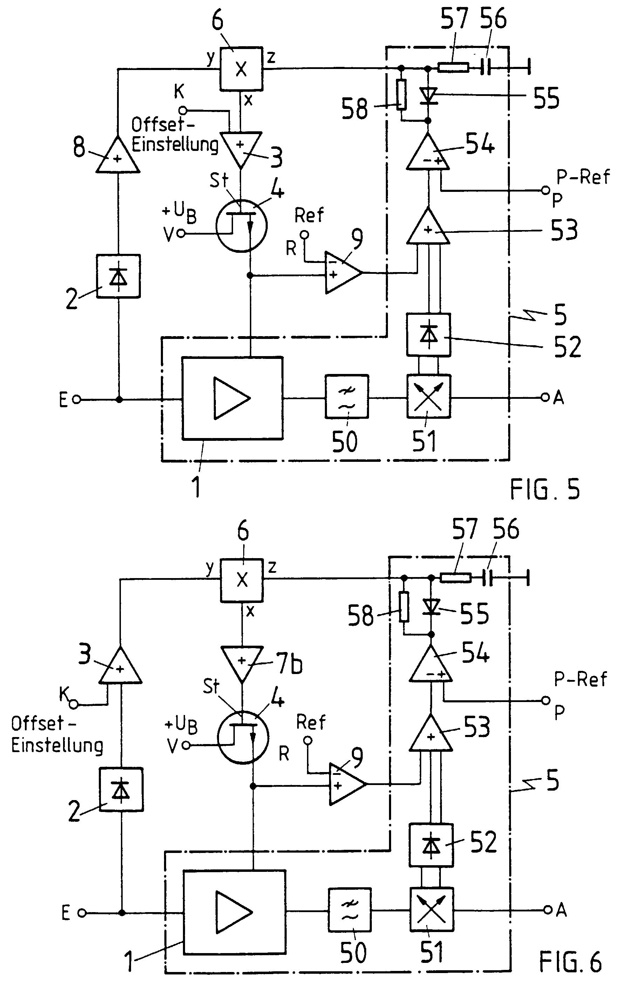

In FIG. 5 ist ein zweites Ausführungsbeispiel des erfindungsgemäßen Verstärkers gezeigt. Es unterscheidet sich von dem in FIG. 3 gezeigten Verstärker dadurch, daß ein Leistungsregelkreis 5 mit PI-Verhalten ("PI-Regler") vorgesehen ist, der den Spitzenwert der Hüllkurve am Ausgang A des Verstärkers 1 nach dem an der Klemme P anliegenden Sollwert P-Ref regelt. Neben den bereits beschriebenen (FIG. 4) Komponenten Tiefpaßfilter 50, Richtkoppler 51, Hüllkurvendetektor 52 und Summierverstärker 53 enthält dieser Regler als zusätzliche Komponenten einen Operationsverstärker 54 entsprechender Verstärkung sowie einen mit Widerständen 57 und 58 und einen Kondensator 56 beschalteten Gleichrichter 55 zur Bildung zweier unterschiedlicher Regelzeitkonstanten, und zwar einer schnellen Zeitkonstante (für die Rückregelung auf niedrigere Signalpegel-Werte) und einer langsamen Zeitkonstante (für die Hochregelung auf höhere Signalpegel-Werte). Der Multiplizierer 6 verknüpft hier den Hüllkurvenstellkreis (bestehend aus den bereits in FIG. 3 erläuterten Komponenten Hüllkurvendetektor 2, Operationsverstärker 3, Stellglied 4 sowie einen als Verstärker wirkenden Operationsverstärker 8) mit dem Spitzenwert-PI-Regelkreis 5. Das Verhältnis Offset-Einstellung zu Hüllkurvenspitzenwert ist hier beeinflußbar durch die Ausgangsgröße z des PI-Reglers 5.

Ein Komparator 9 begrenzt über den PI-Regler 5 zusätzlich die maximale Aussteuerung des Stellgliedes 4 durch Vergleich mit einer Referenz-Spannung Ref an Punkt R.

Das in FIG. 6 gezeigte dritte Ausführungsbeispiel des erfindungsgemäßen Verstärkers unterscheidet sich von den in FIG. 5 gezeigten Ausführungsbeispiel dadurch, daß das Verhältnis der Offset-Spannung U_{B}^{min} am Ausgang des Stellgliedes 4 zum Hüllkurvenspitzenwert im wesentlichen konstant gehalten wird, indem der als Addierer wirkende Operationsverstärker 3 zwischen Hüllkurvendetektor 2 und Multiplizierer 6 geschaltet ist und zwischen Multiplizierer 6 und Steuereingang St des Stellgliedes 4 zusätzlich ein als Verstärker wirkender Operationsverstärker 7b geschaltet ist.

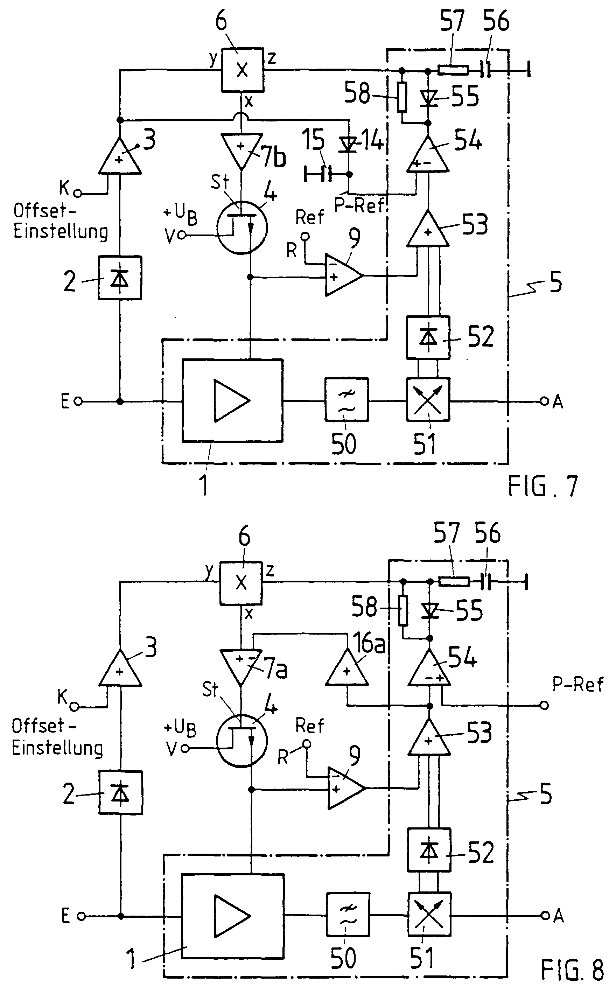

Das in FIG. 7 gezeigte vierte Ausführungsbeispiel des erfindungsgemäßen Verstärkers unterscheidet sich von dem in FIG. 6 gezeigten Ausführungsbeispiel dadurch, daß zur Erzeugung der Soll-Größe P-Ref das Ausgangssignal des als Addierer wirkenden Operationsverstärker 3 benutzt wird, das über die als Integrator wirkende Schaltung aus Diode 14 und Kondensator 15 als Spitzenwert dem Operationsverstärker 54 des PI-Reglers 5 zugeführt wird und somit einen Wert für die Soll-Größe P-Ref liefert, der aus dem maximalen Ansteuersignal am Eingang E des Verstärkers 1 gewonnen wird.

Das in FIG. 8 gezeigte fünfte Ausführungsbeispiel des erfindungsgemäßen Verstärkers unterscheidet sich von dem in FIG. 6 gezeigten Ausführungsbeispiel dadurch, daß nicht nur der Spitzenwert des Ausgangssignals am Ausgang A des Verstärkers 1 durch den PI-Regler 5 geregelt wird, sondern - über den Operationsverstärker 16a - im Operationsverstärker 7a ein zusätzlicher (dynamischer) Momentanwertvergleich der Hüllkurven am Eingang E und Ausgang A des Verstärkers 1 vorgenommen wird, um die Linearität des Ausgangssignals am Ausgang A des Verstärkers 1 weiter zu verbessern.

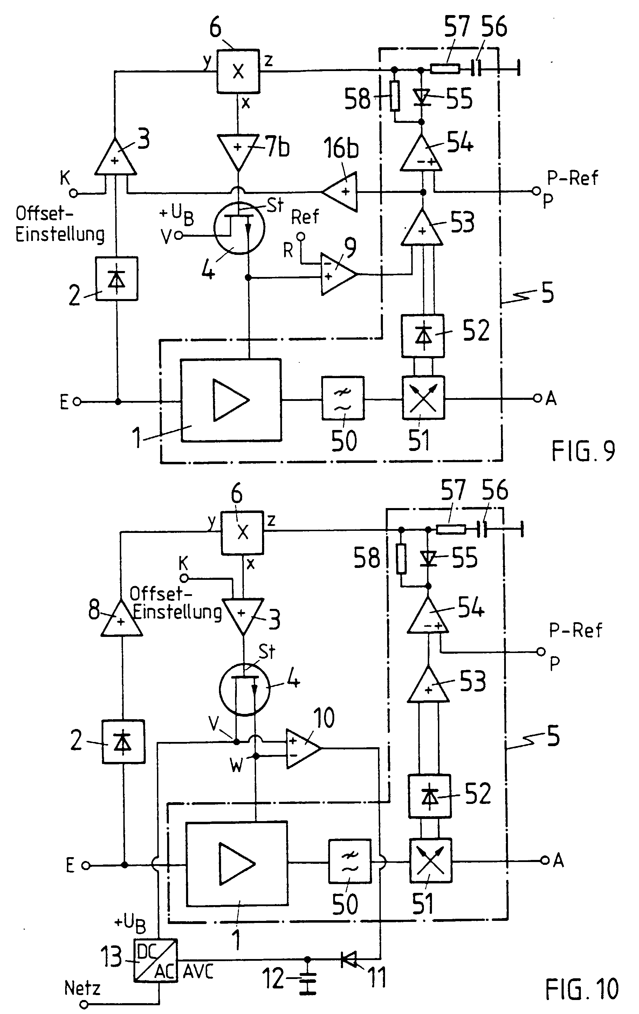

Das in FIG. 9 gezeigte sechste Ausführungsbeispiel des erfindungsgemäßen Verstärkers unterscheidet sich von dem in FIG. 8 gezeigten Ausführungsbeispiel dadurch, daß der dynamische Momentanwertvergleich der Hüllkurven vom Eingang E und Ausgang A des Verstärkers 1 im "Addierer" 3 vorgenommen wird und dadurch die Dynamik der Einflußnahme der Eingangsgröße z des Multiplizierers 6 (und damit der Ausgangsgröße z des PI-Reglers 5) auf den Momentanwert der Versorgungsspannung U_{B} des Verstärkers 1 veränderbar ist.

Das in FIG. 10 gezeigte siebte Ausführungsbeispiel des erfindungsgemäßen Verstärkers unterscheidet sich von dem in FIG. 5 gezeigten Ausführungsbeispiel dadurch, daß ein zusätzlicher (aus einem als Komparator wirkenden Operationsverstärker 10, einer Diode 11 und einem Kondensator 12 bestehender) Integralregler dafür sorgt, daß die Differenz des Spitzenwertes am Ausgang W des Stellgliedes 4 zum Eingangswert +U_{B} am Punkt V nicht unnötig groß wird. Dadurch wird die Verlustleistung im Stellglied 4 verringert. Das bedeutet, daß die von einem an das Netz angeschlossenen Wechselspannungs/Gleichspannungs-Wandler 13 gelieferte Versorgungsspannung +U_{B} des Verstärkers 1 am Punkt V den am Ausgang A des Verstärkers 1 vorliegenden lastabhängigen Erfordernissen (Fehlanpassung) der Aussteuerung am Ausgang des Stellgliedes 4 über den Integralregler 10-12 angepaßt wird. Damit können die Wirkungsgrade auch bei auftretenden Verstärkungs-Frequenzgang des Verstärkers 1 optimiert werden.

Die anhand der Ausführungsbeispiele der FIG. 3 bis 10 gezeigte Linearisierung insbesondere von HF-Breitband-Leistungsverstärkern (1 in den Figuren 3 bis 10) mittels eines linearen Stellglieds (4 in den Figuren 3 bis 10) durch Hüllkurvensteuerung der Versorgungsspannung (U_{B} in den Figuren 1, 3 bis 10) ist insbesondere durch folgende Punkte gekennzeichnet:
- ein "Quasi"-Schaltbetrieb der Verstärkungselemente (z.B. Transistoren) in einem Bereich von z.B. über 90 % des Aussteuerbereiches des Verstärkers mit etwa 70 bis 80 % Wirkungsgrad ist möglich (Wirkungsgrad von herkömmlichen Linearverstärkern: ca. 30 bis 40 %); auch bei einem Stehwellenverhältnis bis etwa S≃3 bleibt der Wirkungsgrad dabei nahezu konstant;
- ca. doppelte Ausgangsleistung des Verstärkers bei gleicher Versorgungsspannung U_{B} gegenüber konventionellen Linearverstärkern ist erreichbar;
- die Linearität ist relativ unabhängig von der Linearität der Verstärkungselemente, z.B. der Transistoren, da die Leistung über ein lineares (+U_{B})-Stellglied gesteuert und vorzugsweise in der Spitze geregelt wird;
- die Verwendung eines konventionellen PI-Reglers als Hauptregelkreis ist möglich mit allen bekannten Vorteilen wie: einfacher Aufbau, stabiles Regelverhalten bzw. - bei den Ausführungsbeispielen der Figuren 5 bis 7 und 10 - geringe Verzerrungen durch externe Störleistung, da der Einsatz eines selektiven Richtkopplers möglich ist, weil der PI-Reglerzweig 5 die durch die selektiven Zusätze des Richtkopplers verursachten zusätzlichen Signallaufzeiten ohne weiteres toleriert;
- der Hüllkurvendetektor erfordert keinen eng tolerierten Eingangspegel (d.h. keinen nur geringe Schwankungen aufweisenden, praktisch konstanten Pegel), da nur der Spitzenwert der Hüllkurve über den PI-Regler geregelt wird;
- die Endstufe kann in konventioneller Technik ausgeführt werden, allerdings zweckmäßigerweise mit einer Spitzenspannungsbegrenzung wegen des Quasi-Schaltbetriebs;
- die Verlustleistung des Verstärkers beträgt bei den Betriebsarten F1 bzw. CW nur etwa die Hälfte, bei 4PSK sogar nur etwa ein Drittel der bisherigen Werte, wobei F1 für Fernschreibfunk (Frequenzumtastung), CW für Continuous-Wave und 4PSK für Vierphasenumtastung (n x 90°-Phasentastung mit n = 1, 2, 3, 4) steht.

Die Erfindung ist nicht auf die beschriebenen Ausführungsbeispiele beschränkt, sondern sinngemäß auf weitere anwendbar. Insbesondere ist die Erfindung nicht auf die in den Ausführungsbeispielen angegebenen HF-Frequenzbereiche des Nutzsignals beschränkt; vielmehr kann die Erfindung auch zur Verstärkung von Nutzsignalen herangezogen werden, die in ganz anderen Frequenzbereichen liegen. Beispielsweise können auch Sender für den ELF(Extremely-Low-Frequency)- bzw. VLF (Very-Low-Frequency)-Bereich z.B. für weltweite Kommunikationssysteme, insbesondere für Unterwasseranwendungen mit Verstärkern ausgerüstet werden, die nach der Erfindung arbeiten. Es können aber auch Sender für den UHF (Ultra-High-Frequency)-Bereich mit solchen Verstärkern ausgerüstet werden. Letzteres bietet sich vor allem für Zellenfunk-Kommunikationssysteme an, die mit Vielkanal-Leistungsverstärkern arbeiten.

Ferner ist es möglich, daß nicht die Einhüllende des Nutzsignals zur Ansteuerung des linearen Stellgliedes verwendet wird, sondern direkt das Modulationssignal.

Anstelle eines linearen Stellgliedes in Form eines Leistungstransistors (z.B. Bipolar- oder Insulated-Gate-Bipolartransistor oder MOS-Feldeffekttransistor) kann schließlich auch ein PDM-Steller vorgesehen werden, wodurch der Gesamtwirkungsgrad des Verstärkersystems - wenn auch nur geringfügig - weiter erhöht werden kann.

## Patentansprüche

1. Verfahren zum linearen Verstärken eines niederfrequent modulierten Nutzsignals mittels eines an eine Versorgungsspannung angeschlossenen Verstärkers, dessen Versorgungsspannung ausgehend von einem Mindestwert (U_{B}^{min}), der nicht unterschritten wird, in ihrem zeitlichen Verlauf in Abhängigkeit von der Einhüllenden des Nutzsignals nachgeführt wird, dergestalt, daß der Verstärker (1) bei kleineren Signalamplitudenwerten der Einhüllenden des Nutzsignals im linearen Arbeitsbereich betrieben und bei größeren Signalamplitudenwerten in die Kompression gesteuert wird; wobei der Verstärker über den 1dB-Kompressionspunkt hinaus ausgesteuert wird und daß das Ausgangssignal des Verstärkers in einem Tiefpaß einer Oberwellenfilterung unterzogen wird.

2. Verfahren nach Anspruch 1, dadurch gekennzeichnet,
- daß der Mindestwert (U_{B}^{min}) der Versorgungsspannung (U_{B}) so ausgewählt wird, daß die Versorgungsspannung (U_{B}) , von diesem Mindestwert (U_{B}^{min}) ausgehend, mit größer werdender Signalamplitude der Einhüllenden des Nutzsignals ansteigt, dergestalt, daß der Verstärker (1), ausgehend von der Signalamplitude Null, mit größer werdender Signalamplitude zunächst im linearen Arbeitsbereich betrieben wird und dann allmählich in die Kompression gesteuert wird;
oder
- daß innerhalb des zulässigen Signalamplitudenbereichs der Einhüllenden des Nutzsignals ein bestimmter Signalamplitudenwert als Schwellenwert ausgewählt wird; daß für die zulässigen Signalamplituden der Einhüllenden des Nutzsignals, die kleiner oder gleich diesem Schwellenwert sind, die Versorgungsspannung (U_{B}) auf dem Mindestwert (U_{B}^{min}) konstant oder zumindest annähernd konstant gehalten wird und der Verstärker (1) im linearen Arbeitsbereich betrieben wird und für die übrigen zulässigen Signalamplituden, die größer als dieser Schwellenwert sind, die Versorgungsspannung (U_{B}), von diesem Mindestwert (U_{B}^{min}) ausgehend, proportional oder zumindest annähernd proportional zur momentanen Signalamplitude der Einhüllenden des Nutzsignals verändert wird und der Verstärker (1) durch das Nutzsignal in die Kompression gesteuert wird.

3. Verfahren nach Anspruch 2, dadurch gekennzeichnet, daß der Mindestwert (U_{B}^{min}) der Versorgungsspannung (U_{B}) oder der Schwellenwert kleiner als die maximal mögliche Versorgungsspannung (U_{B}) oder der Schwellenwert kleiner als der maximal zulässige Signalamplitudenwert der Einhüllenden des Nutzsignals , vorzugsweise kleiner als das 0,5-fache dieses Maximalwertes, vorzugsweise kleiner als das 0,4-fache dieses Maximalwertes ist und insbesondere im Bereich des 0,03-0,3-fachen dieses Maximalwertes, vorzugsweise bei etwa dem 0,1-fachen oder bei etwa dem 0,2-fachen dieses Maximalwertes liegt.

4. Verfahren nach einem der vorhergehenden Ansprüche, dadurch gekennzeichnet, daß der Mindestwert (U_{B}^{min}) der Versorgungsspannung (U_{B}) oder der Schwellenwert in Abhängigkeit weiterer Betriebsparameter festgelegt und/oder während des Betriebs des Verstärkers (1) verändert wird, insbesondere in Abhängigkeit vom gemessenen mittleren Verstärkerwirkungsgrad und/oder von dem ermittelten mittleren Modulationsgrad und/oder von dem ermittelten mittleren Klirrfaktor des Verstärkerausgangssignals und/oder von der ermittelten momentanen Betriebstemperatur des Verstärkers.

5. Verfahren nach einem der vorhergehenden Ansprüche, dadurch gekennzeichnet, daß der Verstärker (1) maximal in etwa bis zum 5dB-Kompressionspunkt, vorzugsweise bis in etwa zum 3dB-Kompressionspunkt ausgesteuert wird.

6. Verfahren nach einem der vorhergehenden Ansprüche, dadurch gekennzeichnet, daß die Ausgangsleistung des Verstärkers (1) bei Leistungswerten im Bereich der Spitzenleistung zusätzlich über eine Regeleinheit, vorzugsweise über einen PI-Regler auf einen vorgegebenen Soll-Wert geregelt wird.

7. Verfahren nach einen der vorhergehenden Ansprüche, dadurch gekennzeichnet, daß die Ausgangsspannung des Verstärkers (1) auf Werte unterhalb eines vorgegebenen maximalen spannungswertes begrenzt wird.

8. Verstärkeranordnung zum Durchführen des Verfahrens nach einem der vorhergehenden Ansprüche, bei dem der Eingang des Verstärkers zusätzlich über einen Hüllkurvendetektor mit einem variablen Verstärker verbunden ist, dessen Ausgang die Versorgungsspannung des Verstärkers steuert, wobei der Ausgang des Verstärkers über eine Regelschaltung mit dem Steuereingang des variablen Verstärkers verbunden ist, dadurch gekennzeichnet,
- daß die Versorgungsspannung (U_{B}) über einen variablen Verstärker in Form eines linearen Stellglieds (4) dem Verstärker (1) zugeführt ist;
- daß dem Verstärkerausgang ein Oberwellenfilter (50) nachgeschaltet ist;
- daß ein Operationsverstärker (3) in den Weg zwischen Eingang (E) des Verstärkers (1) und Versorgungsspannung des Verstärkers (1) geschaltet ist;
- daß der Operationsverstärker (3) den bestimmten Amplitudenwert einstellt;
- daß die Regelschaltung in Form einer PI-Regelschaltung (5) ausgebildet ist;
- daß die PI-Regelschaltung (5) über einen in den aus Hüllkurvendetektor (2), Operationsverstärker (3) und Stellglied (4) gebildeten Steuerkreis geschalteten Multiplizierer (6) mit dem Steuereingang (St) des Stellgliedes (4) verbunden ist.

9. Verstärker nach Anspruch 8, dadurch gekennzeichnet, daß dem Operationsverstärker (3) zur Einstellung des bestimmten Amplitudenwerts zusätzlich eine vorzugsweise einstellbare Vergleichsspannung zugeführt ist.

10. Verstärker nach Anspruch 8, dadurch gekennzeichnet, daß der Operationsverstärker (3) entweder zwischen Multiplikator (6) und Hüllkurvendetektor (2) oder zwischen Multiplikator (6) und Steuereingang (St) des Stellgliedes (4) geschaltet ist.

11. Verstärker nach einem der Ansprüche 8 oder 10, dadurch gekennzeichnet, daß zwischen Multiplikator (6) einerseits und Steuereingang (St) des Stellgliedes (4) und/oder Hüllkurvendetektor (2) andererseits mindestens ein weiterer Operationsverstärker (7a) zu Steuer- oder Regelzwecken und/oder mindestens ein weiterer Steuer- oder Regelsignal-Verstärker (7b bzw. 8) geschaltet ist oder sind.

12. Verstärker nach Anspruch 11, mit zwischen Multiplikator (6) und Steuereingang (St) des Stellgliedes (4) geschaltetem weiteren Operationsverstärker (7a), dadurch gekennzeichnet, daß das dem PI-Komparator (54) der PI-Regelschaltung (5) zugeführte und dort mit dem PI-Referenzsignal (P-Ref) verglichene Signal zusätzlich über einen dritten Signalverstärker (16a) dem weiteren Operationsverstärker (7a) als Vergleichssignal zugeführt ist.

13. Verstärker nach einem der Ansprüche 10 oder 11, mit zwischen Hüllkurvendetektor (2) und Multiplikator (6) geschaltetem Operationsverstärker (3), dadurch gekennzeichnet, daß das dem PI-Komparator (54) der PI-Regelschaltung (5) zugeführte und dort mit dem PI-Referenzsignal (P-Ref) verglichene Signal zusätzlich über einen weiteren dritten Signalverstärker (16b) dem Operationsverstärker (3) als weiteres Vergleichssignal zugeführt ist.

14. Verstärker nach einem der Ansprüche 10 oder 11, mit zwischen Hüllkurvendetektor (2) und Multiplikator (6) geschaltetem Operationsverstärker (3), dadurch gekennzeichnet, daß dem PI-Komparator (54) der PI-Regelschaltung (5) das PI-Referenzsignal (P-Ref) zugeführt ist, indem der Ausgang des Operationsverstärker (3) zusätzlich über eine Diode (14) und einen Integrator (15) mit dem Referenz-Eingang des PI-Komparators (54) der PI-Regelschaltung (5) verbunden ist.

15. Verstärker nach einem der Ansprüche 8 bis 14, dadurch gekennzeichnet,
- daß die Versorgungsspannung (U_{B}) über einen zwischen dem Stellglied (4) und dem Verstärker (1) vorgesehenen Abgriff einem Komparator (9) zugeführt ist;
- daß dem Komparator (9) eingangsseitig eine weitere Vergleichsspannung (Ref) zugeführt ist;
- daß der Ausgang des Komparators (9) über einen Summierverstärker (53) der PI-Regelschaltung (5) mit dem PI-Komparator (54) verbunden ist.

16. Verstärker nach einem der Ansprüche 8 bis 14 dadurch gekennzeichnet,
- daß die Versorgungsspannung (U_{B}) in einem eingangsseitig an ein Wechselspannungsnetz (Netz) angeschlossenen, regelbaren Wechselspannung/Gleichspannungs-Wandler (13) erzeugt ist;
- daß die Versorgungsspannung (U_{B}) zusätzlich über Abgriffe vor und nach dem Stellglied (4) einem weiteren Komparator (10) zugeführt ist;
- daß der Ausgang des weiteren Komparators (10) über eine weitere Diode (11) und einem weiteren Kondensator (12) mit dem Regeleingang des Wechselspannungs/Gleichspannungs-Wandlers (13) verbunden ist.

17. Verstärker nach einem der Ansprüche 8 bis 16, dadurch gekennzeichnet, daß der Komparator (9) oder der weitere Komparator (10) und/oder der Summierverstärker (53) und/oder der PI-Komparator (54) und/oder der mindestens eine weitere Steuer- oder Regelsignal-Verstärker (7b bzw. 8) und/oder der dritte Signalverstärker (16a) oder der weitere dritte Signalverstärker (16b) in Form eines Operationsverstärkers realisiert ist oder jeweils in Form eines Operationsverstärkers realisiert sind.

18. Verstärker nach einem der Ansprüche 8 bis 17, dadurch gekennzeichnet, daß das Stellglied (4) in Form eines als Emitterfolger geschalteten Leistungstransistors, vorzugsweise in Form eines Bipolartransistors oder Insulated-Gate-Bipolartransistors (IGBT) oder MOS-Feldeffekttransistors realisiert ist oder in Form eines pulsdauermodulierten Stellgliedes.

19. Verstärker nach einen der Ansprüche 8 bis 18, dadurch gekennzeichnet, daß das Stellglied (4) im Netzteil des Verstärkers (1) enthalten ist.

20. Verstärker nach einem der Ansprüche 8 bis 19, gekennzeichnet durch die Verwendung in einem Sender, vorzugsweise einem Einseitenbandsender vorzugsweise des ELF-, VLF-, LW-, MW-, KW- oder UHF-Bereichs oder in den Sendestationen von Zellenfunksystemen vorzugsweise des C- oder D-Telefonnetzes.

## Claims

1. Method for linear amplification of a low-frequency modulated mains signal by means of an amplifier, which is connected to a supply voltage and the supply voltage of which starting from a minimum value (U_{B}^{min}) not to be fallen below is adjusted in its course over time in dependence on the envelopes of the used signal, in such a manner that the amplifier (1) operates in the linear working range for smaller signal value amplitudes of the envelopes of the used signal and is controlled in compression for larger signal amplitude values, wherein the amplifier is driven to full output beyond the 1dB compression point, and that the output signal of the amplifier is subjected to a harmonic wave filtering in a low-pass filter.

2. Method according to claim 1, characterised in that
- the minimum value (U_{B}^{min}) of the supply voltage (U_{B}) is so selected that the supply voltage (U_{B}), from which this minimum value (U_{B}^{min}) starts out, rises with increasing signal amplitude of the envelopes of the used signal in such a manner that the amplifier (1), starting from the signal amplitude of zero, with increasing signal amplitude initially operates in the linear working range and is then gradually controlled in compression,
or
- within the permissible signal amplitude range of the envelopes of the used signal a specific signal amplitude value is selected as threshold value, and for the permissible signal amplitudes of the envelopes of the used signal which are less than or equal to this threshold value the supply voltage (U_{B}) is kept constantly or at least approximately constantly at the minimum value (U_{B}^{min}) and the amplifier (1) is operated in the linear working range and for the remaining permissible signal amplitudes which are greater than this threshold value the supply voltage (U_{B}), which starts from this minimum value (U_{B}^{min}) is varied proportionally or at least approximately proportionally to the instantaneous signal amplitude of the envelopes of the used signal and the amplifier (1) is controlled in compression by the used signal.

3. Method according to claim 2, characterised in that the minimum value (U_{B}^{min}) of the supply voltage (U_{B}) or the threshold value is smaller than the maximum possible supply voltage (U_{B}) or the threshold value is smaller than the maximum permissible signal amplitude value of the envelopes of the used signal, preferably smaller than 0.5 of this maximum value, preferably is smaller than 0.4 of this maximum value and especially in the range of 0.03 to 0.3 of this maximum value, preferably lies at about 0.1 or at about 0.2 of this maximum value.

4. Method according to one of the preceding claims, characterised in that the minimum value (U_{B}^{min}) of the supply voltage (U_{B}) or the threshold value is fixed in dependence on further operating parameters and/or is varied during operation of the amplifier (1), especially in dependence on the measured mean efficiency of the amplifier and/or on the ascertained mean degree of modulation and/or on the ascertained mean distortion factor of the amplifier output signal and/or on the ascertained instantaneous operating temperature of the amplifier.

5. Method according to one of the preceding claims, characterised in that the amplifier (1) is driven to full output at the most up to about the 5dB compression point, preferably up to about the 3dB compression point.

6. Method according to one of the preceding claims, characterised in that the output power of the amplifier (1) for power values in the region of the peak power is additionally regulated by way of a regulating unit, preferably a proportional-integral regulator, to a preset target value.

7. Method according to one of the preceding claims, characterised in that the output voltage of the amplifier (1) is limited to values below a preset maximum voltage value.

8. Amplifier arrangement for carrying out the method according to one of the preceding claims, in which the input of the amplifier is additionally connected by way of an envelope curve detector with a variable amplifier, the output of which controls the supply voltage of the amplifier, wherein the output of the amplifier by way of a regulating circuit with the control input of the variable amplifier, characterised in that
- the supply voltage (U_{B}) is fed to the amplifier (1) by way of a variable amplifier in the form of a linear selling element (4);
- a harmonic wave filter (50) is connected behind the amplifier output;
- an operational amplifier (3) is connected into the path between input (E) of the amplifier (1) and supply voltage of the amplifier (1);
- the operational amplifier (3) sets the specific amplitude value;
- the regulating circuit is constructed in the form of a proportional-integral regulating circuit (5);
- the proportional-integral regulating circuit (5) is connected with the control input (St) of the selling element (4) by way of a multiplier (6) connected into the control circuit formed by envelope curve detector (2), operational amplifier (3) and selling element (4).

9. Amplifier according to claim 8, characterised in that the operational amplifier (3) is additionally fed a preferably adjustable comparison voltage for the selling of the specific amplitude value.

10. Amplifier according to claim 8, characterised in that the operational amplifier (3) is connected either between multiplier (9) and envelope curve detector (2) or between multiplier (6) and control input (St) of the selling element (4).

11. Amplifier according to one of claims 8 and 10, characterised in that at least one further operational amplifier (7a) for control or regulating purposes and/or at least one further control or regulating signal amplifier (7b or 8) is or are connected between multiplier (6) on the one hand and control input (St) of the selling element (4) and/or envelope curve detector (2) on the other hand.

12. Amplifier according to claim 11, with further operational amplifiers (7a) connected between multiplier (6) and control input (St) of the setting element (4), characterised in that the signal fed to the proportional-integral comparator (54) of the proportional-integral regulating circuit (5) and compared there with the proportional-integral reference signal (P-Ref) is additionally fed by way of a third signal amplifier (16a) to the further operational amplifier (7a) as a comparison signal.

13. Amplifier according to one of claims 10 and 11, with operational amplifiers (3) connected between envelope curve detector (2) and multiplier (6), characterised in that the signal fed to the proportional-integral comparator (54) of the proportional-integral regulating circuit (5) and compared there with the proportional-integral reference signal (P-Ref) is additionally fed by way of a further third signal amplifier (16b) to the operational amplifier (3) as further comparison signal.

14. Amplifier according to one of claims 10 and 11, with operational amplifiers (3) connected between envelope curve detector (2) and multiplier (6), characterised in that the proportional-integral reference signal (P-ref) is fed to the proportional-integral comparator (54) of the proportional-integral regulating circuit (5), in that the output of the operational amplifier (3) is additionally connected by way of a diode (14) and an integrator (15) with the reference input of the proportional-integral comparator (54) of the proportional-integral regulating circuit (5).

15. Amplifier according to one of claims 8 to 14, characterised in that
- the supply voltage (U_{B}) is fed to a comparator (8) by way of a tap provided between the setting element (4) and the amplifier (1);
- a further comparison voltage (Ref) is fed to the comparator (9) at the input side;
- the output of the comparator (9) is connected with the proportional-integral comparator (54) by way of a summating amplifier (53) of the proportional-integral regulating circuit (5).

16. Amplifier according to one of claims 8 to 14, characterised in that
- the supply voltage (U_{B}) is generated in a regulable alternating-voltage-to-direct-voltage converter (13) connected at the input side to an alternating voltage mains (mains);
- the supply voltage (U_{B}) is additionally fed to a further comparator (10) by way of taps in front of and behind the selling element (4);
- the output of the further comparator (10) is connected by way of a further diode (11) and a further capacitor (12) with the regulating input of the alternating-voltage-to-direct-voltage converter (13).

17. Amplifier according to one of claims 8 to 16, characterised in that the comparator (9) or the further comparator (10) and/or the summating amplifier (53) and/or the proportional-integral comparator (54) and/or the at least one further control or regulating signal amplifier (7b or 8) and/or the third signal amplifier (16a) or the further third signal amplifier (16b) is realised in the form of an operational amplifier or are each realised in the form of an operational amplifier.

18. Amplifier according to one of claims 8 to 17, characterised in that the selling element (4) is realised in the form of a power transistor connected as an emitter-follower, preferably in the form of a bipolar transistor or insulated gate bipolar transistor (IGBT) or MOS field effect transistor or in the form of a pulse-duration-modulated setting element.

19. Amplifier according to one of claims 8 to 18, characterised in that the selling element (4) is contained in the mains part of the amplifier (1).

20. Amplifier according to one of claims 8 to 19, characterised by the use in a transmitter, preferably a single sideboard transmitter preferably of the ELF, VLF,LW, MW, KW or UHF range or in the transmitting stations of cellular radio systems preferably of the C or D telephone network.

## Revendications

1. Procédé pour l'amplification linéaire d'un signal utile modulé à basse fréquence, à l'aide d'un amplificateur raccordé à une tension d'alimentation et dont l'allure dans le temps de la tension d'alimentation est asservie à partir d'une valeur minimale (U_{B}^{min}), au-dessous de laquelle la tension d'alimentation ne tombe pas, en fonction de l'enveloppe du signal utile de telle sorte que pour des valeurs assez faibles de l'amplitude du signal de l'enveloppe du signal utile, l'amplificateur (1) fonctionne dans la gamme de travail linéaire et, dans le cas de valeurs plus élevées d'amplitude du signal, l'amplificateur est commandé pour effectuer la compression, l'amplificateur étant modulé au-delà du point de compression à 1 dB, et que le signal de sortie de l'amplificateur est soumis à un filtrage d'harmoniques dans un filtre passe-bas.

2. Procédé selon la revendication 1, caractérisé en ce
- que la valeur minimale (U_{B}^{min}) de la tension d'alimentation (U_{B}) est sélectionnée de telle sorte que la tension d'alimentation (U_{B}) augmente, à partir de cette valeur minimale (U_{B}^{min}), avec une amplitude, qui augmente, du signal de l'enveloppe du signal utile de telle sorte qu'à partir de l'amplitude zéro du signal, lorsque l'amplitude du signal augmente, l'amplificateur (1) fonctionne tout d'abord dans la gamme de travail linéaire, puis est commandé progressivement pour effectuer la compression;
ou
- que dans la gamme admissible des amplitudes de signal de l'enveloppe du signal utile, une valeur d'amplitude déterminée du signal est sélectionnée en tant que valeur de seuil; que pour les amplitudes admissibles de signal de l'enveloppe du signal utile, qui sont inférieures ou égales à cette valeur de seuil, la tension d'alimentation (U_{B}) est maintenue constante ou au moins approximativement constante à la valeur minimale (U_{B}^{min}) et l'amplificateur (1) fonctionne dans la gamme de travail linéaire, et que pour les autres amplitudes admissibles de signal, qui mont supérieures à cette valeur de seuil, la tension d'alimentation (U_{B}) est modifiée, à partir de cette valeur minimale (U_{B}^{min}), d'une manière proportionnelle ou au moins approximativement proportionnelle à l'amplitude instantanée de signal de l'enveloppe du signal utile et l'amplificateur (1) est commandé par le signal utile, pour effectuer la compression.

3. Procédé selon la revendication 2, caractérisé en ce que la valeur minimale (U_{B}^{min}) de la tension d'alimentation (U_{B}) ou la valeur de seuil est inférieure à la tension maximale possible d'alimentation (U_{B}) ou la valeur de seuil est inférieure à la valeur maximale admissible d'amplitude de signal de l'enveloppe du signal utile, et de préférence est inférieure à 0,5 fois cette valeur maximale, et de préférence est inférieure à 0,4 fois cette valeur maximale, et notamment se situe dans la gamme de 0,03 - 0,3 fois cette valeur maximale et de préférence est égale approximativement à 0,1 fois ou est égale approximativement à 0,2 fois cette valeur maximale.

4. Procédé selon l'une des revendications précédentes, caractérisé en ce que la valeur minimale (U_{B}^{min}) de la tension d'alimentation (U_{B}) ou la valeur de seuil est fixée en fonction d'autres paramètres de fonctionnement et/ou est modifiée pendant le fonctionnement de l'amplificateur (1), notamment en fonction du rendement moyen mesuré de l'amplificateur et/ou du degré moyen déterminé de modulation et/ou du facteur moyen déterminé de distorsion du signal de sortie de l'amplificateur et/ou de la température instantanée déterminée de fonctionnement de l'amplificateur.

5. Procédé selon l'une des revendications précédentes, caractérisé en ce que l'amplificateur (1) est commandé au maximum approximativement jusqu'au point de compression à 5 dB et de préférence approximativement jusqu'au point de compression à 3 dB.

6. Procédé selon l'une des revendications précédentes, caractérisé en ce que pour des valeurs de puissance au voisinage de la puissance maximale, la puissance de sortie de l'amplificateur (1) est réglée en supplément au moyen d'une unité de régulation, de préférence au moyen d'un régulateur proportionnel et intégral sur une valeur de consigne prédéterminée.

7. Procédé selon l'une des revendications précédentes, caractérisé en ce que la tension de sortie de l'amplificateur (1) est limitée à des valeurs inférieures à la valeur de tension prédéterminée.

8. Dispositif amplificateur pour la mise en oeuvre du procédé selon l'une des revendications précédentes, selon lequel l'entrée de l'amplificateur est reliée en outre, par l'intermédiaire d'un détecteur de courbe enveloppe, à un amplificateur variable dont le signal de sortie commande la tension d'alimentation de l'amplificateur, la sortie de l'amplificateur étant reliée à l'entrée de commande de l'amplificateur variable par l'intermédiaire d'un circuit de régulation, caractérisé en ce
- que la tension d'alimentation (U_{B}) est envoyée à l'amplificateur (1) par l'intermédiaire d'un amplificateur variable réalisé sous la forme d'un organe de réglage linéaire (4);
- qu'un filtre d'harmoniques (50) est branché en aval de la sortie de l'amplificateur;
- qu'un amplificateur opérationnel (3) est branché dans le trajet entre l'entrée (E) de l'amplificateur (1) et la tension d'alimentation de l'amplificateur (1);
- que l'amplificateur opérationnel (3) règle la valeur d'amplitude déterminée;
- que le circuit de régulation est agencé sous la forme d'un circuit de régulation à action proportionnelle et intégrale (5);
- que le circuit de régulation à action proportionnelle intégrale (5) est relié à l'entrée de commande (St) de l'organe de réglage (4) par l'intermédiaire d'un multiplicateur (6) branché dans le circuit de commande formé par le détecteur de courbe enveloppe (2), l'amplificateur opérationnel (3) et l'organe de réglage (4).

9. Amplificateur selon la revendication 8, caractérisé en ce que pour le réglage de la valeur de l'amplitude déterminée, une tension de comparaison de préférence réglable est envoyée en supplément à l'amplificateur opérationnel (3).

10. Amplificateur selon la revendication 8, caractérisé en ce que l'amplificateur opérationnel (3) est branché soit entre le multiplicateur (6) et le détecteur de courbe enveloppe (2), soit entre le multiplicateur (6) et l'entrée de commande (St) de l'organe de réglage (4).

11. Amplificateur selon l'une des revendications 8 ou 10, caractérisé en ce qu'au moins un autre amplificateur opérationnel (7a) utilisé dans un but de commande de régulation et/ou au moins un autre amplificateur du signal de commande ou de régulation (7b ou 8) est ou sont branchés entre le multiplicateur (6) d'une part et l'entrée de commande (St) de l'organe de réglage (4) et/ou le détecteur de courbe enveloppe (2) d'autre part.

12. Amplificateur selon la revendication 11, comprenant un autre amplificateur opérationnel (7a) branché entre le multiplicateur (6) et l'entrée de commande (St) de l'organe de réglage (4), caractérisé en ce que le signal, qui est envoyé au comparateur à action proportionnelle et intégrale (54) du circuit de régulation à action proportionnelle (55) et y est comparé au signal de référence à action proportionnelle et intégrale (P-Ref), est en outre envoyé en tant que signal de comparaison à l'autre amplificateur opérationnel (7a), par l'intermédiaire d'un troisième amplificateur de signaux (7a).

13. Amplificateur selon l'une des revendications 10 ou 11, comportant un amplificateur opérationnel (3) branché entre le détecteur de courbe enveloppe (2) et le multiplicateur (6), caractérisé en ce que le signal, qui est envoyé au comparateur à action proportionnelle et intégrale (54) du circuit de régulation à action proportionnelle et intégrale (5) et y est comparé au signal de référence à action proportionnelle et intégrale (P-Ref) est en outre envoyé en tant qu'autre signal de comparaison à l'amplificateur opérationnel (3), par l'intermédiaire d'un troisième autre amplificateur de signaux (16b).

14. Amplificateur selon l'une des revendications 10 ou 11, comportant un amplificateur opérationnel (3) branché entre le détecteur de courbe enveloppe (2) et le multiplicateur (6), caractérisé en ce que le signal de référence à action proportionnelle et intégrale (P-Ref) est envoyé au comparateur à action proportionnelle et intégrale (54) du circuit de régulation à action proportionnelle et intégrale (5), par le fait que la sortie de l'amplificateur opérationnel (3) est en outre reliée à l'entrée de référence du comparateur à action proportionnelle et intégrale (54) du circuit d'évaluation à action proportionnelle et intégrale (5), par l'intermédiaire d'une diode (14) et d'un intégrateur (15).

15. Amplificateur selon l'une des revendications 8 à 14, caractérisé en ce
- que la tension d'alimentation (U_{B}) est envoyée à un comparateur (9) par l'intermédiaire d'une prise prévue entre l'organe de réglage (4) et l'amplificateur (1);
- qu'une autre tension de comparaison (Ref) est envoyée au côté entrée du comparateur (9);
- que la sortie du comparateur (9) est reliée au comparateur à action proportionnelle et intégrale (54) par l'intermédiaire d'un amplificateur additionneur (53) du circuit de régulation à action proportionnelle et intégrale (5).

16. Amplificateur selon l'une des revendications 8 à 14, caractérisé en ce
- que la tension d'alimentation (U_{B}) est produite dans un convertisseur à tension alternative/tension continue réglable, connecté côté entrée à un réseau à tension alternative (réseau);
- que la tension d'alimentation (U_{B}) est en outre envoyée à un autre comparateur (10) par l'intermédiaire de prises situées en amont et en aval de l'organe de réglage (4);
- que la sortie de l'autre comparateur (10) est reliée par l'intermédiaire d'une autre diode (11) et d'un autre condensateur (12) à l'entrée de régulation du convertisseur tension alternative/tension continue (13).

17. Amplificateur selon l'une des revendications 8 à 16, caractérisé en ce que le comparateur (9) ou l'autre comparateur (10) et/ou l'amplificateur additionneur (53) et/ou le comparateur à action proportionnelle et intégrale (54) et/ou le au moins un autre amplificateur du signal de commande ou du signal de régulation (7b ou 8b) et/ou le troisième amplificateur de signaux (16a) ou le troisième autre amplificateur de signaux (16b) est réalisé sous la forme d'un amplificateur opérationnel ou sont réalisés respectivement sous la forme d'un amplificateur opérationnel.

18. Amplificateur selon l'une des revendications 8 à 17, caractérisé en ce que l'organe de réglage (4) est réalisé sous la forme d'un transistor de puissance branché en émetteur suiveur, de préférence sous la fane d'un transistor bipolaire ou d'un transistor bipolaire à grille isolée (IGBT) ou d'un transistor à effet de champ MOS ou sous la fane d'un organe de réglage modulé selon une modulation d'impulsions en durée.

19. Amplificateur selon l'une dus revendications 8 à 18, caractérisé en ce que l'organe de réglage (4) est contenu dans la partie du réseau de l'amplificateur (1).

20. Amplificateur selon l'une des revendications 8 à 19, caractérisé par l'utilisation, dans un émetteur, de préférence un émetteur à bande latérale unique de préférence de la gamme ELF, VLF, LW, MW, KW ou UHF ou dans les postes d'émission de systèmes radio cellulaires de préférence du réseau téléphonique C ou D.
